# EUROPEAN PATENT SPECIFICATION

(11) **EP 1 565 048 B1**
(45) Date of publication and mention of the grant of the patent: **11.04.2007**
(21) Application number: 04250781.4
(22) Date of filing: 13.02.2004
(51) Int. Cl.: H05K 5/00

(54) **Rack mounted equipment case**
In einem Gestell montiertes Gerätegehäuse
Boîtier pour équipement, monté dans un bâti

(43) Date of publication of application: 17.08.2005
(73) Proprietor: Zero Cases (UK) Limited, Smethwick, West Midlands, B66 1BZ (GB)
(72) Inventor: Eddleston, Alan, Smethwick West Midlands B66 1BZ (GB); Grice, Alan, Smethwick West Midlands B66 1BZ (GB); Whitbread, Peter, Smethwick West Midlands B66 1BZ (GB); Boyce, Sam, Smethwick West Midlands B66 1BZ (GB)
(74) Representative: Franks, Robert Benjamin

(56) References cited:
- EP-A- 0 965 785
- EP-A- 1 133 221
- EP-A- 1 298 973
- DE-A- 3 624 682
- DE-A- 3 933 643
- DE-U- 29 606 194

## Description

### Technical Field

The invention disclosed here relates to a case for rack mounted equipment.

### Background of the Invention

There is a type of metal case used in industrial applications that is called a rack mounted equipment case used for accommodating rack-mount electronics, which is made to standard or other sizes - typically 19 inch (approx 46cm) but clearly the cases can be designed for any size. Rack mounted equipment cases are typically made from aluminium but may be made from other materials. They usually have a body tube that has a rectangular cross section closed at each end by removable covers. This shape makes them amenable to stacking in racks or stacking one on top of another. While these cases have many applications and uses, it is not uncommon to use them as transportable, protective housings for electronic components in harsh environmental conditions where the components are subjected to strong mechanical shocks, vibration or inclement weather.

In certain applications, rack mounted equipment cases are used to network electronics in one case with another or to a broader network. In these particular applications, the rack mounted equipment case often has a connector panel from which various kinds of cable and other electrical connectors or fittings protrude. The connector panel is usually attached to the case by small bolts or screws in a manner so that it can be removed in order to access internal components. However, since the connector fittings are also located on the panel, it is necessary to disconnect corresponding cables and wiring before the panel can be opened. What this means is that use of the electronics inside the case is either lost or shut down during a maintenance or other operation.

### Technical Problem

The invention relates to rack mounted equipment cases that house electronic components for use in electronics, industrial, military or related applications where it is necessary to protect interior components from extreme environmental conditions, shock and vibration. It is normally necessary for the case to be sealed.

It is also a problem to provide electromagnetic (EMI / RFI) shielding to protect the internal electronics in the case from being disrupted by external sources whilst protecting external electronics from being disrupted from the internal items.

Because the cases may be used in vehicles, the case must provide a high degree of shock protection and be suitable for allowing the use of the equipment during transport. If the electronics are operational while in the sealed and shielded environment of the case, access to the interior of the case is essential for maintenance, inspection or other purposes and it is not acceptable to disconnect connectors to enable such access.

The connector panel also needs to be protected from knocks that may dislodge the connectors and for health and safety reasons to protect employees working in the vicinity.

In many applications the space and weight allowance available for the rack mounted equipment cases may be limited.

### Solution of the Invention

The invention disclosed and described here is an improved case for rack mounted equipment that provides a solution to the technical problems discussed above. In particular it enables access to and maintenance of electronics within the case without necessarily shutting them down or disconnecting them from other components. A case that is constructed in accordance with the invention is also well-suited for stacking, because the connector fittings do not protrude outwardly relative to the outermost envelope occupied by the case when it sits in a rack or against a wall. There is normally a space and consequently weight saving. Finally, the rack case design disclosed here provides rapid and easy access to components inside the case for maintenance purposes.

In accordance with the invention there is provided a case for rack mounted equipment comprising a body tube having two ends, a connector panel secured to the body tube at a first end, and a removable lid at at least one end, wherein a surface of the connector panel is recessed relative to an outer profile of the case to provide protection for the connector panel.

Preferably the rack mounted equipment case has a reduced-height, removable lid on the first end, and the connector panel surface is recessed relative to the reduced-height lid.

The connector panel surface is protected below the reduced-height lid and provides an area for permanent placement of cable connectors, switches and similar fittings.

The reduced-height lid can be removed easily for allowing access to the interior of the case without disconnecting the fittings. Therefore, in some instances it is possible to undertake maintenance operations while interior electronic components continue to operate.

In an alternative configuration, the connector panel is secured inwardly of and closes the first end. Such a case could have just one removable lid or cover at the other end.

Rack mounted equipment cases in accordance with the invention protect the cables and connectors and makes it much simpler to shield and seal the contents of the case when a cover or lid is not there. These case configurations save space and weight.

The lids may be connected to the cases by a plurality of straps or latches. Depending on the size of the case, a pair of latches, one on each side, is used to connect the reduced-height lid to the case. Two or more pairs of latches may be used to connect the full-height lid on the other end of the case.

In order to facilitate stable stacking of one case on another, each case preferably has a plurality of feet, located on a bottom panel of the body tube typically near a corner of the case. A plurality of feet locators are similarly positioned on a top panel of the body tube of the case. The feet and feet locators are shaped to nest with each other and are arranged in an identical pattern so that one case can be stacked on top of another in a stable manner.

In EP 1298973 there is disclosed an equipment item of the rack mountable type comprising a tubular casing having a connector panel wherein a surface of the connector panel is recessed relative to an outer profile of the case. The equipment item may be fitted into a further case for rack mount equipment, to protect the equipment item.

These various features are described in greater detail below.

### Brief Description of the Drawings

In order that the invention may be well understood two embodiments thereof will now be described, by way of example only, with reference to the accompanying diagrammatic drawings. In the drawings, like reference numerals and letters refer to like parts throughout the various views, and wherein:
Fig. 1 is a pictorial view of a rack mounted equipment case constructed in accordance with a first embodiment of the invention;
Fig. 2 is a view like Fig. 1, but is taken from a position underneath the case;
Fig. 3 is view like Fig. 1, but shows the reduced-height lid removed from the case;

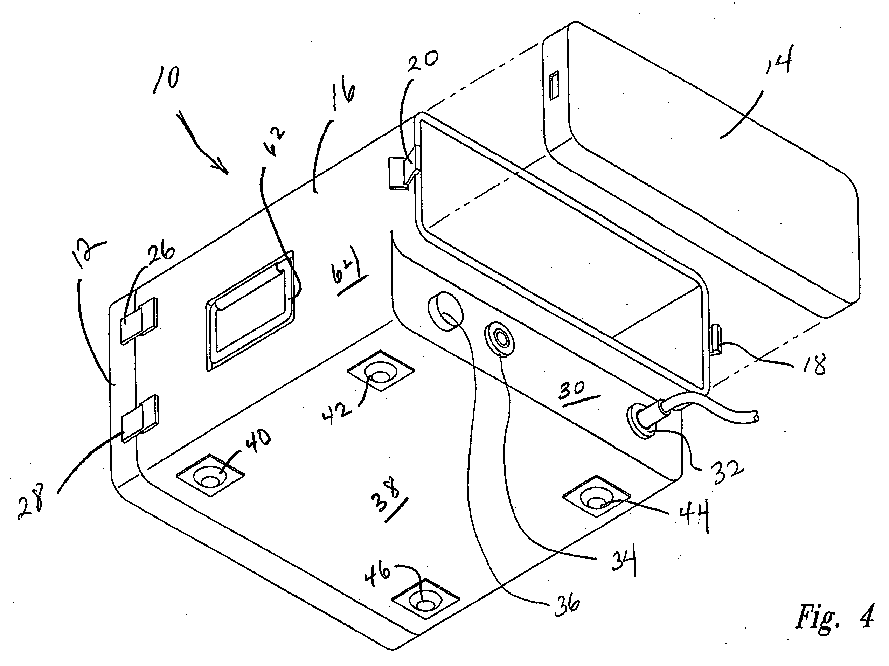

Fig. 4 is a view like Fig. 3, but is taken from below the case;

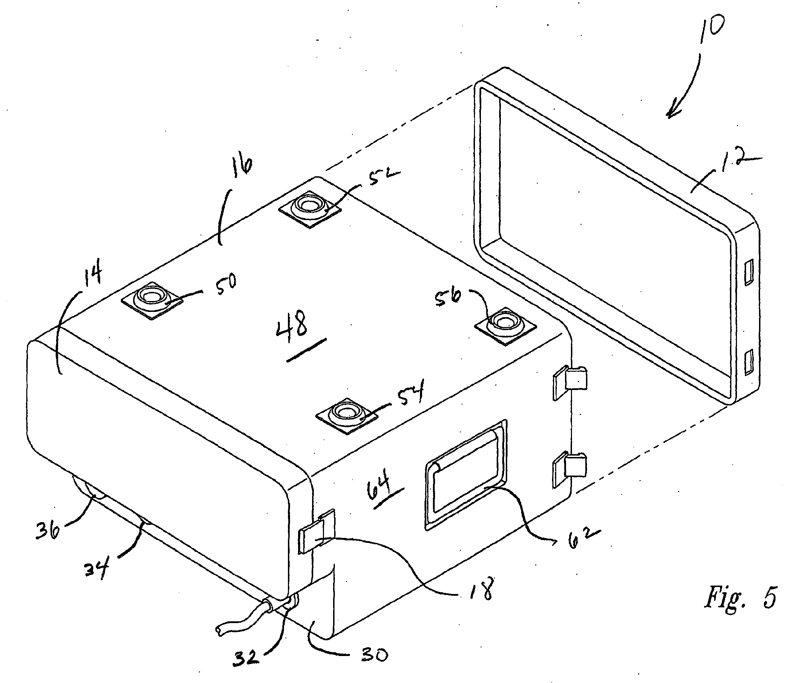

Fig. 5 is another pictorial view that shows the full-height lid removed from the case;

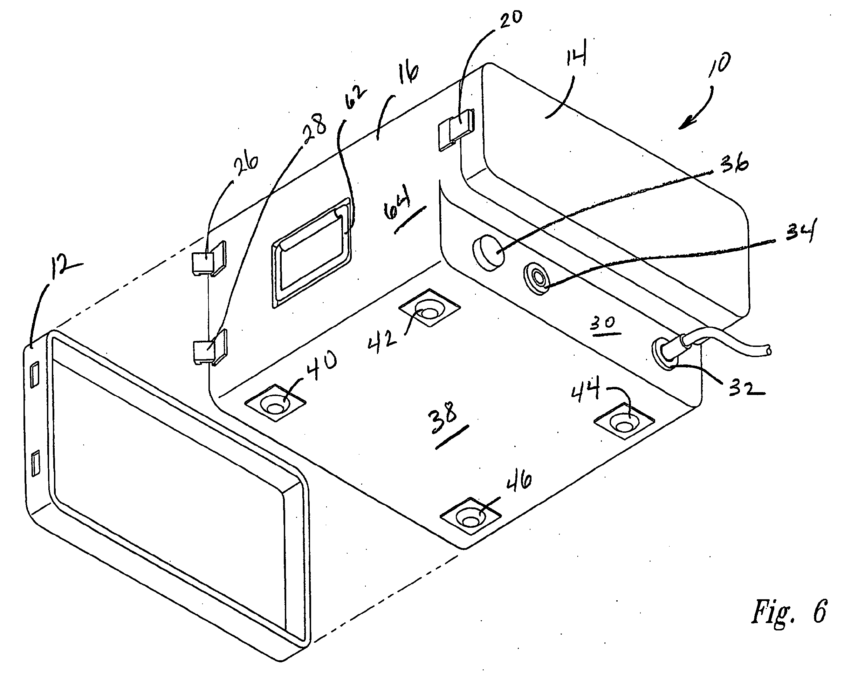

Fig. 6 is a view like Fig. 5, but is taken from below the case;

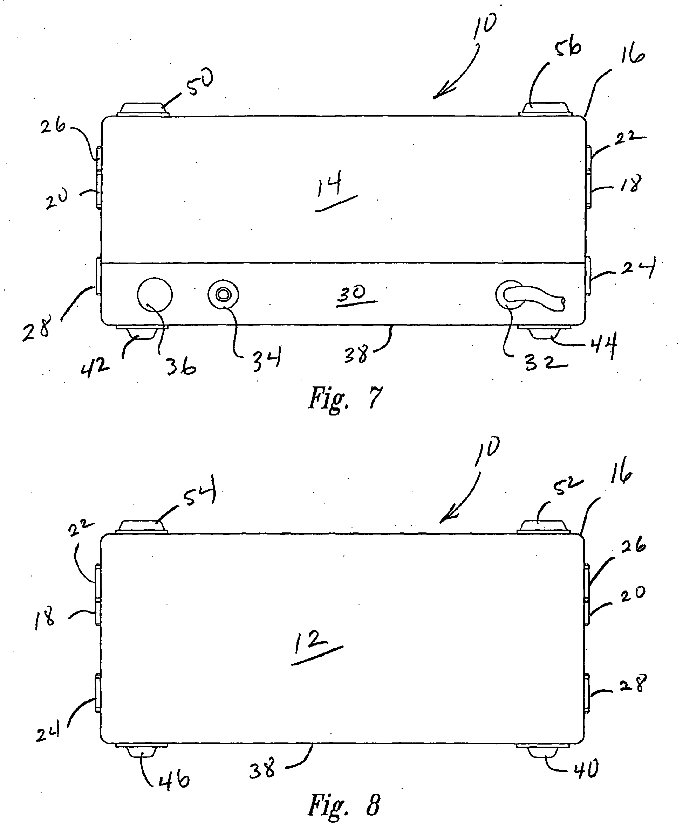

Fig. 7 is a view of the reduced-height end of the case;
Fig. 8 is a view of the full-height end of the case;

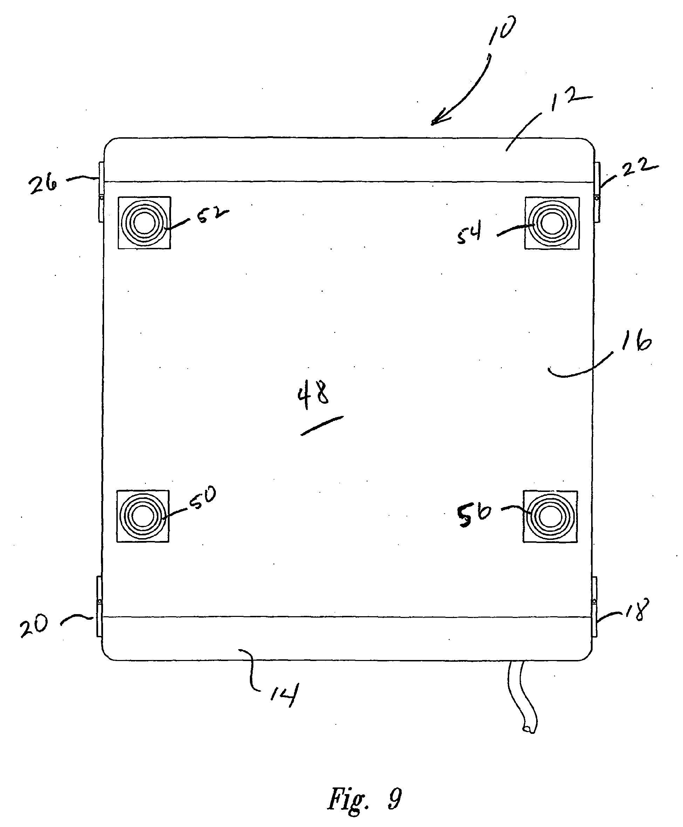

Fig. 9 is a top view of the case;

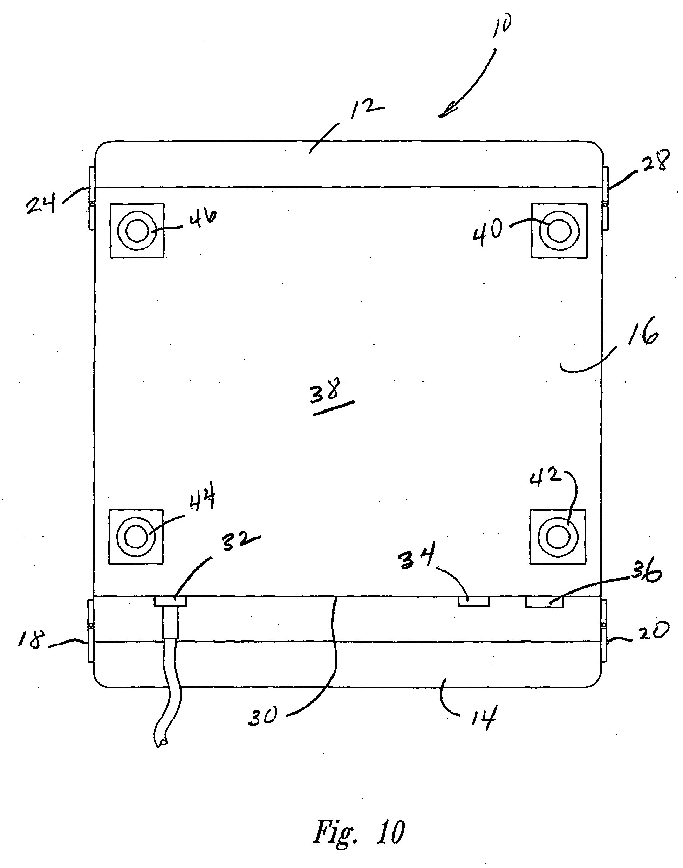

Fig. 10 is a bottom view of the case;

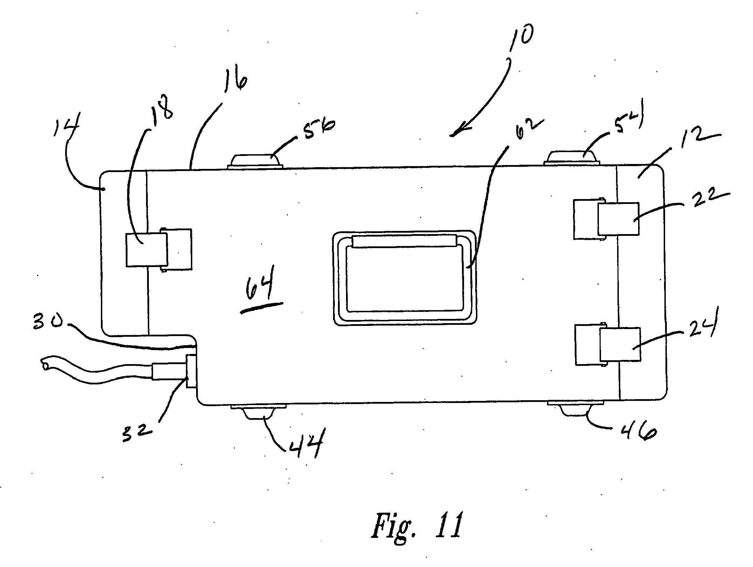

Fig. 11 is a side view of the case;
Fig. 12 illustrates a plurality of cases stacked one on top of another;
Fig. 13 is a cross-sectional view showing a case foot about to be nested within a foot locator;
Fig. 14 is a view like Fig. 13, but shows the foot nested within the foot locator; and
Fig. 15 shows a perspective view of a second embodiment of a rack mounted equipment case.

### Best Mode for Carrying Out the Invention

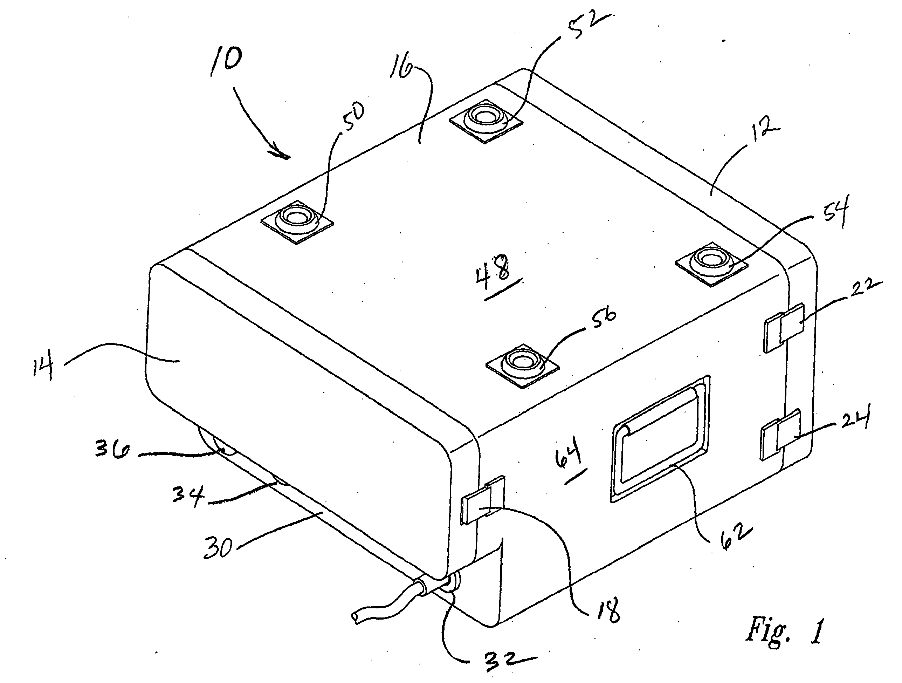

Referring now to the drawings, and first to Fig. 1, shown generally at 10 is a rack mounted equipment case constructed in accordance with an exemplary embodiment of the invention. The case 10 can be made from aluminum, plastics, composites or other materials via a variety of manufacturing techniques. The size of the case 10 may vary depending on the intended application. However, these factors are not considered to be germane to the invention.

The case 10 has a full-height, removable lid or cover 12 on one end of a body tube 16. On the other end, the case has a reduced-height, removable lid or cover 14. The reduced-height lid 14 is considered to be the "front" of the case, while the full-height lid 12 is the "back." It will be appreciated that in reality the case can be used either way round.

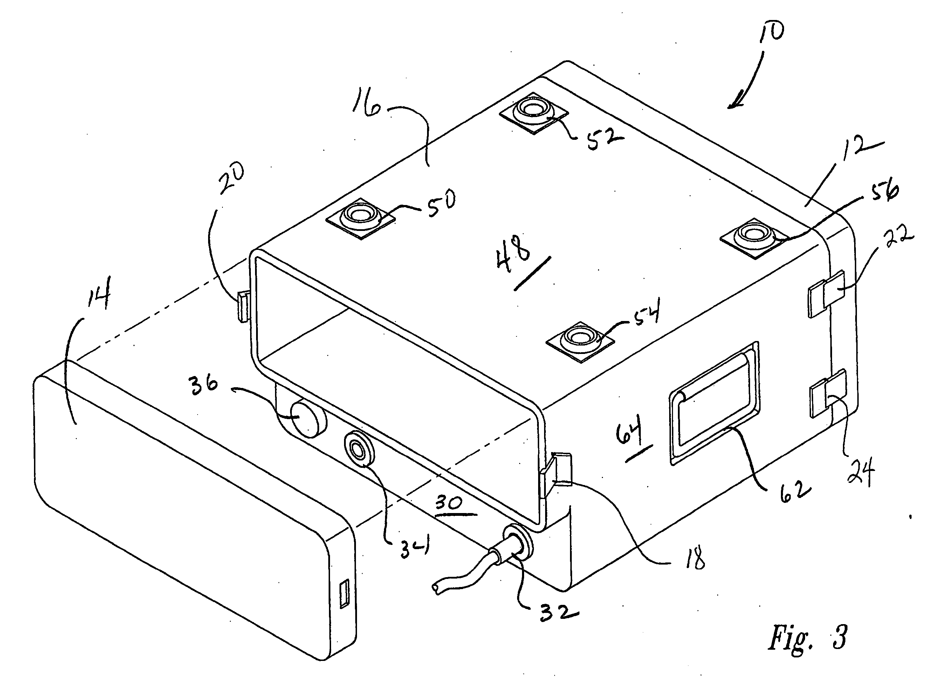

Both the front and back lids 14, 12 are connected to the body 16 of the case by a plurality of straps or latches. For example, referring to Fig. 3, the front lid 14 is connected to the body 16 by a pair of latches 18, 20, one on each side of the case. The rear lid is connected by four latches 22, 24, 26, 28, one pair to a side. The latches are of conventional construction. There are other ways for implementing the connection of the lids 12, 14 to the case body 16 such as, for example, using thumbwheel screws or other quick release fittings that could be mounted in recesses in the lids. These screws would connect to threaded bores in the case body 16. However, alternative connections are not illustrated in the drawings.

Directing attention again to Fig. 1, a connector panel surface 30 is positioned below and recessed inwardly relative to an outer profile of the case and of the front lid 14. The connector panel could be above the lid 14 or two connector panels may be provided both above and below the reduced-height lid. The connector panel surface 30 has a number of cable and electrical or other fittings 32, 34, 36. These fittings are conventional in nature and depend on the specific components inside the case. When the case 10 is used to house electronics, the electrical connections can remain in place as the front lid 14 is removed from the case, or the back lid 12, for that matter. As mentioned above, this enables maintenance or other kinds of work to be performed inside the case without necessarily shutting down operation of the components. Also, it is very easy to access the interior case because of the quick release mechanism provided by latches 18, 20 in the front, or 22, 24, 26, 28 in the back, depending on the situation.

Although the lid 12 has been shown as a full height lid it will be appreciated that the case may have a reduced height lid and one or two connector panels 30 at each end.

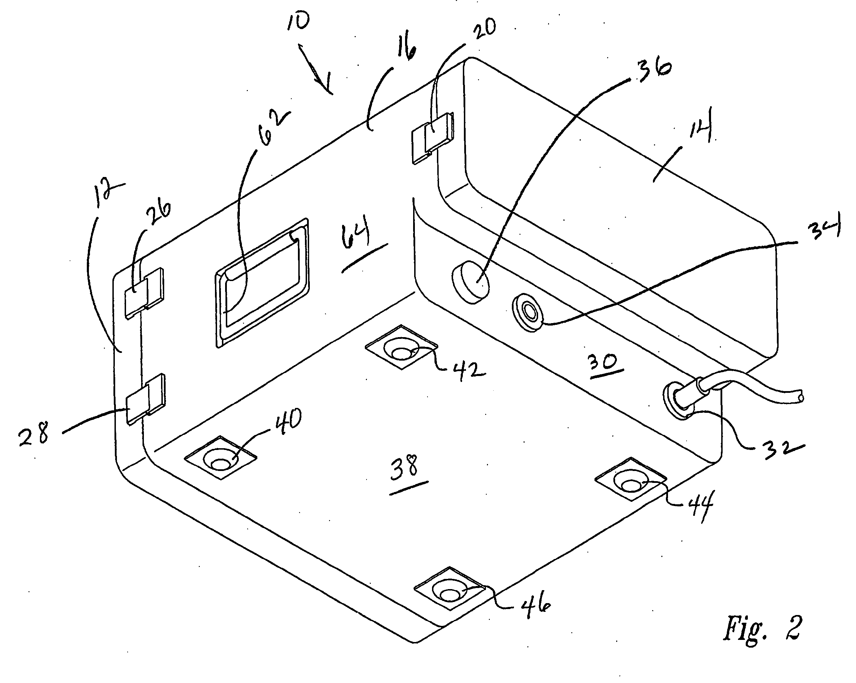

Referring to Fig. 2, the bottom surface 38 of the case 10 has four feet 40, 42, 44, 46, which are mounted to the case in a conventional manner. Likewise, the top surface 48 of the case has a series of four foot locators 50, 52, 54, 56. As illustrated in the drawings, these items are located near the corners of the case's body 16.

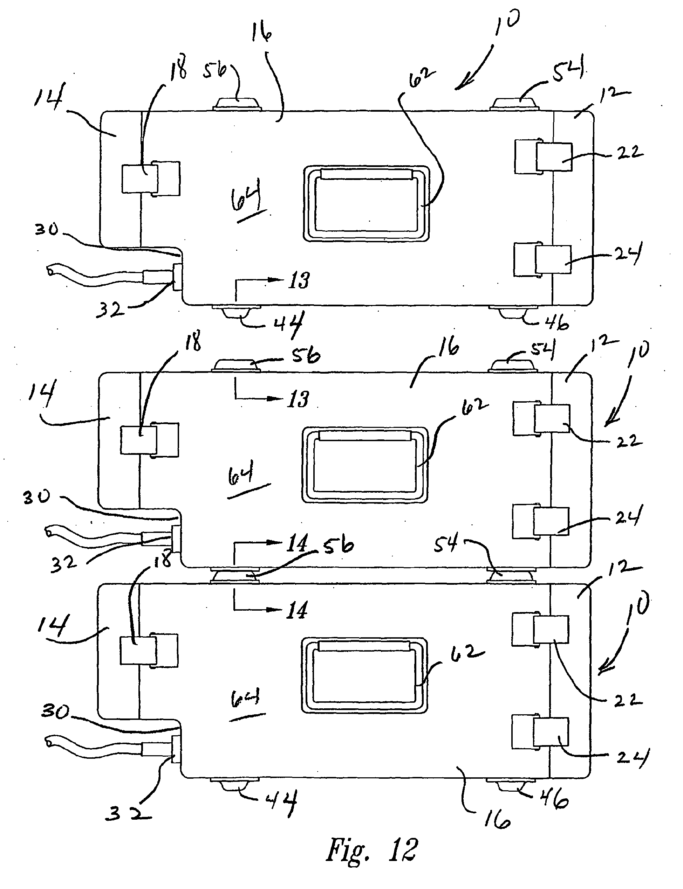

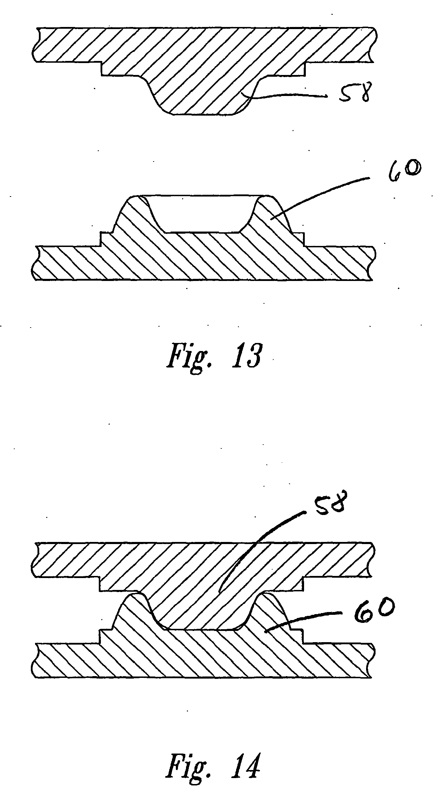

The foot locators 50, 52, 54, 56 are arranged in an identical pattern to the feet 40, 42, 44, 46. Referring to Figs. 13 and 14, reference numeral 58 illustrates a cross-sectional view of a typical foot. Reference numeral 60 illustrates a cross-sectional view of a typical foot locator. When one case 10 is stacked on top of another, the foot 58 nests within foot locator 60 in the manner illustrated in Fig. 14. This enables the stacking arrangement illustrated in Fig. 12. In order to improve the ease of handling individual cases, a recessed or surface-mounted handle 62 can be connected to each side 64 of the case, in the manner shown in the drawings.

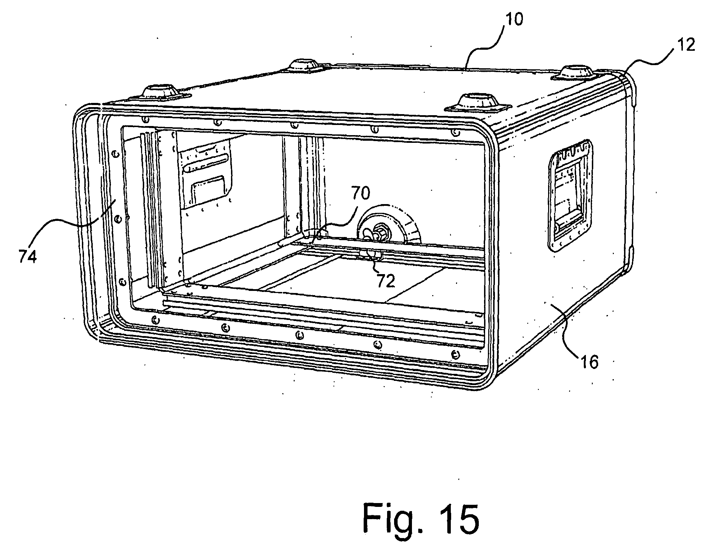

In a second embodiment as shown in Figure 15, the rack mounted equipment case 10 is of similar configuration to that described above and similar parts are identified by the same reference numerals with the addition of a prime symbol.

A normal inner frame 70 is suspended inside a body tube 16' on shock mounts 72. The case has one removable cover 12 and at the other end a flanged extrusion 74 is secured or welded to an inner wall of the body tube 16 inboard of the first end. A connector panel (not shown) is secured to the extrusion 74 so that it is recessed relative to the outer profile of the case 10' inwardly of the end face of the body tube 16'. The cables and connectors pass through the connector panel as in the previous embodiment to the electronics mounted within. The connector panel closes the whole of the end. A further protective cover may be available for providing enhanced protection when the electronics are not in use. The connector panel provides for shielding and sealing of the contents when the cover is not there. This results in space and weight savings.

A case that is constructed in the above manner may be used for many different kinds of military or industrial applications and other uses where unusual environmental conditions come into play. While it is not shown in the drawings, case 10 could be constructed with ventilation cut-outs or pressure relief valves, depending on whether or not the case is designed to be air-tight. As mentioned above, dimensions can vary depending on the particular application.

## Claims

1. A case (10) for rack mounted equipment comprising a body tube (16) having two ends,
a connector panel (30) secured to the body tube (16) at a first end,
and **characterised by**:
a removable lid (12,14) at at least one end;
wherein a surface (30) of the connector panel is recessed relative to an outer profile of the case (10), to provide protection for the connector panel.

2. A case (10) for rack mounted equipment as claimed in claim 1, having a reduced-height, removable lid (14) on the first end, and the connector panel surface(30) is recessed relative to the reduced-height lid (14).

3. A case (10) for rack mounted equipment as claimed in claim 2, wherein the connector panel surface (30) is positioned above or below the reduced-height lid (14).

4. A case (10) for rack mounted equipment as claimed in claim 2 or 3, having a full-height, removable lid (12) on the other end.

5. A case (10) for rack mounted equipment as claimed in any one of the preceding claims, wherein a second recessed connector panel surface is provided on the other end.

6. A case (10) for rack mounted equipment as claimed in claim 1, wherein the connector panel (30') is secured inboard of and closes the first end.

7. A case (10) for rack mounted equipment as claimed in claim 1, having a removable lid (14) on an end, and a connector panel on the same end that is recessed relative to the removable lid.

8. A case (10) for rack mounted equipment as claimed in any one of the preceding claims wherein the or each connector panel surface (30) is permanently secured to the case.

9. A case (10) for rack mounted equipment of claim 1, including a plurality of feet located on a bottom surface of the case, and a plurality of feet locators positioned on a top surface of the case, each foot being shaped to nest within a respective foot locator, the feet and feet locators being arranged in a substantially identical pattern to facilitate stable stacking of one equipment case on another.

10. The case (10) for rack mounted equipment of claim 1, including a plurality of latches for removably connecting each lid to the case.

## Patentansprüche

1. Koffer (10) für in einem Gestell eingebautes Gerät, umfassend eine Gehäuseröhre (16) mit zwei Enden;
ein Anschlussfeld (30), das an einem ersten Ende an der Gehäuseröhre (16) befestigt ist;
und das **gekennzeichnet ist durch**:
einen abnehmbaren Deckel (12,14) an mindestens einem Ende;
wobei eine Oberfläche (30) des Anschlussfelds relativ zu einem Außenprofil des Koffers (10) zurück gesetzt ist, um Schutz für das Anschlussfeld bereitzustellen.

2. Koffer (10) für in einem Gestell eingebautes Gerät nach Anspruch 1 mit einem abnehmbaren Deckel (14) mit reduzierter Höhe am ersten Ende und wobei die Anschlussfeldoberfläche (30) relativ zum Deckel mit reduzierter Höhe (14) zurückgesetzt ist.

3. Koffer (10) für in einem Gestell eingebautes Gerät nach Anspruch 2, wobei die Anschlussfeldoberfläche (30) oberhalb oder unterhalb des Deckels mit reduzierter Höhe (14) angeordnet ist.

4. Koffer (10) für in einem Gestell eingebautes Gerät nach Anspruch 2 oder 3 mit einem abnehmbaren Deckel (12) mit voller Höhe am anderen Ende.

5. Koffer (10) für in einem Gestell eingebautes Gerät nach einem der vorangehenden Ansprüche, wobei eine zweite zurückgesetzte Anschlussfeldoberfläche am anderen Ende bereitgestellt ist.

6. Koffer (10) für in einem Gestell eingebautes Gerät nach Anspruch 1, wobei das Anschlussfeld (30')_{[MT1]} an der Innenseite des ersten Endes befestigt ist und dieses verschließt.

7. Koffer (10) für in einem Gestell eingebautes Gerät nach Anspruch 1 mit einem abnehmbaren Deckel (14) an einem Ende und einem Anschlussfeld am selben Ende, das relativ zum abnehmbaren Deckel zurückgesetzt ist.

8. Koffer (10) für in einem Gestell eingebautes Gerät nach einem der vorangehenden Ansprüche, wobei die, beziehungsweise jede Anschlussfeldoberfläche (30) dauerhaft am Koffer befestigt ist.

9. Koffer (10) für in einem Gestell eingebautes Gerät nach Anspruch 1, umfassend eine Vielzahl von an einer Unterseite des Koffers befindlichen Füßen sowie eine Vielzahl von auf einer Oberseite des Koffers positionierten Fußaufnahmen, wobei jeder Fuß so geformt ist, dass er in einer jeweiligen Fußaufnahme eingreift, wobei die Füße und die Fußaufnahmen in einem im Wesentlichen identischen Muster angeordnet sind, um das stabile Stapeln eines Gerätekoffers auf einem anderen zu erleichtern.

10. Koffer (10) für in einem Gestell eingebautes Gerät nach Anspruch 1, umfassend eine Vielzahl von Riegeln zum abnehmbaren Verbinden jedes Deckels mit dem Koffer.

## Revendications

1. Boîtier (10) pour équipement monté dans un bâti, comportant une enveloppe (16) à deux extrémités;
un panneau de raccordement (30) fixé à l'enveloppe (16) à une première extrémité;
et **caractérisé par** :
un couvercle amovible (12,14) placé au moins à l'une des extrémités;
**caractérisé en ce qu'**une surface (30) du panneau de raccordement est encastrée par rapport à un profil extérieur du boîtier (10), pour assurer la protection du panneau de raccordement.

2. Boîtier (10) pour équipement monté dans un bâti, selon la revendication 1, comportant un couvercle amovible (14) de hauteur réduite à une première extrémité, et un panneau de raccordement dont la surface (30) est encastrée par rapport au couvercle de hauteur réduite (14).

3. Boîtier (10) pour équipement monté dans un bâti, selon la revendication 2, **caractérisé en ce que** la surface du panneau de raccordement (30) est située au-dessus ou au-dessous du couvercle de hauteur réduite (14).

4. Boîtier (10) pour équipement monté dans un bâti, selon la revendication 2 ou la revendication 3, comportant un couvercle amovible (12) de hauteur intégrale à l'autre extrémité.

5. Boîtier (10) pour équipement monté dans un bâti, selon l'une quelconque des revendications précédentes, **caractérisé en ce qu'**un deuxième panneau de raccordement à surface encastrée est prévu à l'autre extrémité.

6. Boîtier (10) pour équipement monté dans un bâti, selon la revendication 1, **caractérisé en ce que** le panneau de raccordement (30'_{[MT1]}) est fixé à l'intérieur de la première extrémité et sert à fermer cette première extrémité.

7. Boîtier (10) pour équipement monté dans un bâti, selon la revendication 1, comportant un couvercle amovible (14) à l'une des extrémités, et un panneau de raccordement à la même extrémité qui est encastré par rapport au couvercle amovible.

8. Boîtier (10) pour équipement monté dans un bâti, selon l'une quelconque des revendications précédentes, **caractérisé en ce que** le ou chaque panneau de raccordement (30) est fixé en permanence au boîtier.

9. Boîtier (10) pour équipement monté dans un bâti, selon la revendication 1, comportant une pluralité de pattes disposées sur une surface inférieure du boîtier, et une pluralité de creux disposés sur une surface supérieure du boîtier et prévus pour le positionnement des pattes, chaque patte étant formée de manière à s'encastrer à l'intérieur de son creux de positionnement correspondant, les pattes et les creux de positionnement étant disposés de manière essentiellement identique pour assurer la stabilité d'empilage d'un boîtier sur un autre.

10. Boîtier (10) pour équipement monté dans un bâti, selon la revendication 1, comportant une pluralité de loquets amovibles qui servent à rattacher chaque couvercle au boîtier.
